# EUROPEAN PATENT SPECIFICATION

(11) **EP 3 331 041 B1**
(45) Date of publication and mention of the grant of the patent: **28.04.2021**
(21) Application number: 16832966.2
(22) Date of filing: 29.07.2016
(51) Int. Cl.: H01L 51/44, H01L 51/46, H01L 51/42, H01L 51/00

(54) **SOLAR CELL**
SOLARZELLE
CELLULE SOLAIRE

(30) Priority: 31.07.2015 JP 2015152800; 01.03.2016 JP 2016039101
(43) Date of publication of application: 06.06.2018
(73) Proprietor: Sekisui Chemical Co., Ltd., Osaka-shi, Osaka 530-0047 (JP)
(72) Inventor: KUREBAYASHI, Tetsuya, Mishima-gun Osaka 618-0021 (JP); AITA, Tetsuya, Mishima-gun Osaka 618-0021 (JP); YUKAWA, Mayumi, Mishima-gun Osaka 618-0021 (JP); ASANO, Motohiko, Mishima-gun Osaka 618-0021 (JP); UNO, Tomohito, Mishima-gun Osaka 618-0021 (JP); HAYAKAWA, Akinobu, Mishima-gun Osaka 618-0021 (JP); MORITA, Takeharu, Mishima-gun Osaka 618-0021 (JP); FUKUMOTO, Yuuichirou, Mishima-gun Osaka 618-0021 (JP)
(74) Representative: Cabinet Beau de Loménie
(86) International application number: PCT/JP2016/072407
(87) International publication number: WO 2017/022687

(56) References cited:
- WO-A1-2014/045021
- WO-A1-2014/191767
- WO-A2-2015/063416
- JP-A- 2016 139 805
- US-A1- 2014 116 509
- HOBEOM KIM ET AL: "Organic solar cells using CVD-grown graphene electrodes", NANOTECHNOLOGY, IOP, BRISTOL, GB, vol. 25, no. 1, 11 December 2013 (2013-12-11), page 14012, XP020255902, ISSN: 0957-4484, DOI: 10.1088/0957-4484/25/1/014012 [retrieved on 2013-12-11]
- WILLIAM H NGUYEN ET AL: "Enhancing the Hole-Conductivity of Spiro-OMeTAD without Oxygen or Lithium Salts by Using Spiro(TFSI) 2 in Perovskite and Dye- Sensitized Solar Cells", JOURNAL OF THE AMERICAN CHEMICAL SOCIETY, vol. 136, 22 July 2014 (2014-07-22), pages 10996-11001, XP055134459, DOI: 10.1021/ja504539w
- A. I. HOFMANN ET AL.: 'An Alternative Anionic Polyelectrolyte for Aqueous PEDOT Dispersions: Toward Printable Transparent Electrodes' ANGEWANDTE CHEMIE INTERNATIONAL EDITION vol. 54, 01 June 2015, pages 8506 - 8510, XP055361923

## Description

### TECHNICAL FIELD

The present invention relates to a solar cell having high photoelectric conversion efficiency and excellent high-temperature, high-humidity durability.

### BACKGROUND ART

Solar cells provided with a laminate (photoelectric conversion layer) having an N-type semiconductor layer and a P-type semiconductor layer disposed between opposing electrodes have been conventionally developed. Such solar cells generate photocarriers (electron-hole pairs) by photoexcitation so that electrons and holes move through the N-type semiconductor and the P-type semiconductor, respectively, to create an electric field.

Most solar cells currently in practical use are inorganic solar cells which are produced using inorganic semiconductors made of silicon or the like. The inorganic solar cells, however, are utilized only in a limited range because their production is costly and upsizing thereof is difficult. Therefore, organic solar cells produced using organic semiconductors instead of inorganic semiconductors (see Patent Literatures 1 and 2) and organic inorganic solar cells combining organic semiconductors and inorganic semiconductors have received attention.

In organic solar cells or organic inorganic solar cells, a hole transport layer is often provided between an anode and a photoelectric conversion layer that contains an N-type semiconductor and a P-type semiconductor. The hole transport layer carries out a function of improving the photoelectric conversion efficiency of the solar cell by allowing electrons and holes generated by photoexcitation to efficiently move without being recombined.

The material of the hole transport layer currently used in most cases is polyethylene dioxythiophene:polystyrene sulfonate (PEDOT:PSS) (see Patent Literature 3). However, PEDOT:PSS is soluble in water to have poor film forming properties. In addition, PEDOT:PSS is insufficient in photoelectric conversion efficiency. Moreover, being strongly acidic, PEDOT:PSS causes deterioration of the solar cell. Non-Patent Literature 1 discloses the use of perfluorinated ionomers (PFI) to form a PEDOT:PSS:PFI film on a graphene anode, PFI being tetrafluoroethylene-perfluoro-3,6-dioxa-4-methyl-7-octenesulphonic acid copolymer). Non-Patent Literature 3 discloses PEDOT:PSTFSIK wherein the PSS of PEDOT:PSS is replaced by a basic polyanion based on a polystyrene backbone with (trifluoromethylsulfonyl)imide (TFSI) side groups.

Further, the use of 2,2',7,7'-tetrakis-(N,N-di-methoxyphenylamine)-9,9'-spirobifluorene (Spiro) and trifluorosulfonyl imide-lithium salt (Li-TFSI) in combination as materials of the hole transport layer is now studied, as in Non-Patent Literature 2 and Patent Literature 4. The use of a hole transport layer containing Spiro and Li-TFSI can achieve higher photoelectric conversion efficiency. In the case of using a hole transport layer containing Spiro and Li-TFSI, however, the solar cell disadvantageously has poor high-temperature, high-humidity durability.

### CITATION LIST

### - Patent Literature

Patent Literature 1: JP 2006-344794 A
Patent Literature 2: JP 4120362 B
Patent Literature 3: JP 2006-237283 A
Patent Literature 4: WO 2014/191767

### - Non-Patent Literature

Non-Patent Literature 1: Kim et al., Nanotechnology, 2014, 25:1, 14012
Non-Patent Literature 2: Nguyen et al., J. Am. Chem. Soc., 2104, 136, 10996-11001
Non-Patent Literature 3: Hofmann et al., Angew. Chem. Int. Ed., 2015, 8506-8510

### SUMMARY OF INVENTION

### - Technical Problem

The present invention aims to, in consideration of the state of the art, provide a solar cell having high photoelectric conversion efficiency and excellent high-temperature, high-humidity durability.

### - Solution to problem

The present invention relates to a solar cell including at least: a photoelectric conversion layer containing an organic-inorganic perovskite as defined in appended claim 1; a hole transport layer; and an anode, the hole transport layer being disposed between the photoelectric conversion layer and the anode, the hole transport layer containing a polymer containing a halogen atom and an organic semiconductor component (1), the polymer containing a halogen atom having a structure that contains a halogen atom and an electron-withdrawing group bonded to a hetero atom as defined in appended claim 1 (herein also referred to as a first aspect of the present invention). The present invention also relates to a solar cell including at least: a photoelectric conversion layer containing an organic-inorganic perovskite as defined in appended claim 7; a hole transport layer; and an anode, the hole transport layer being disposed between the photoelectric conversion layer and the anode, the hole transport layer containing an organic semiconductor component (2), the organic semiconductor component (2) having a structure that contains a halogen atom and an electron-withdrawing group bonded to a hetero atom as defined in appended claim 7 (herein also referred to as a second aspect of the present invention).

The present invention is specifically described in the following.

The present inventors studied about the reason why a solar cell having a hole transport layer containing Spiro and Li-TFSI has poor high-temperature, high-humidity durability. They found out that when Spiro and Li-TFSI are used in combination, Li-TFSI is precipitated or segregated so as not to be able to increase the carrier density sufficiently as a dopant, leading to reduction in photoelectric conversion efficiency in a high-temperature, high-humidity environment. As a result of further intensive studies, they found out that a solar cell achieving both high photoelectric conversion efficiency and excellent high-temperature, high-humidity durability can be obtained by employing, as a dopant, a polymer having a structure that contains a halogen atom and an electron-withdrawing group bonded to a hetero atom and using a hole transport layer containing the polymer having a structure that contains a halogen atom and an electron-withdrawing group bonded to a hetero atom and an organic semiconductor component (first aspect of the present invention). The present inventors also found out that a solar cell achieving both high photoelectric conversion efficiency and excellent high-temperature, high-humidity durability can be obtained by using a hole transport layer containing an organic semiconductor component provided with properties of a polymer having a structure that contains a halogen atom and an electron-withdrawing group bonded to a hetero atom, i.e.; an organic semiconductor component having a structure that contains a halogen atom and an electron-withdrawing group bonded to a hetero atom (second aspect of the present invention). The present invention was thus completed.

The solar cell of the first aspect of the present invention is now described.

The solar cell of the first aspect of the present invention has at least a photoelectric conversion layer, a hole transport layer, and an anode.

The term "layer" as used herein means not only a layer having a clear boundary, but even a layer having a concentration gradient in which contained elements are gradually changed. The elemental analysis of the layer can be conducted, for example, by FE-TEM/EDS analysis of a cross section of the solar cell to confirm the element distribution of a particular element. The term "layer" as used herein means not only a flat thin film-like layer, but also a layer capable of forming an intricate structure together with other layer(s).

The hole transport layer is disposed between the photoelectric conversion layer and the anode.

The hole transport layer contains a polymer containing a halogen atom (hereafter, also referred to as a "halogen-containing polymer") and an organic semiconductor component (1). The halogen-containing polymer has a structure that contains a halogen atom and an electron-withdrawing group bonded to a hetero atom. Having such a hole transport layer, the solar cell of the first aspect of the present invention can exhibit high photoelectric conversion efficiency and excellent high-temperature, high-humidity durability. Though being not clear, the reason for this is presumably that the use of a halogen-containing polymer reduces precipitation or segregation of the halogen-containing polymer as a dopant during formation of a hole transport layer. In addition, since the halogen-containing polymer contains a halogen atom and is soluble in an organic solvent, the effect of facilitating the formation of a hole transport layer is also achieved.

The halogen-containing polymer may be in the form of ions (anion, cation) or the form of salt as long as it has a structure that contains a halogen atom and an electron-withdrawing group bonded to a hetero atom.

The hetero atom is a nitrogen atom for better compatibility with an organic semiconductor component (1) described later.

The electron-withdrawing group in the halogen-containing polymer is not particularly limited, and examples thereof include sulfonyl, sulfide, thioester, thioketone, ester, ether, carbonyl, amide, urethane, sulfinyl, and phosphonyl groups. Any of these electron-withdrawing groups may be used alone or two or more types thereof may be used in combination. One electron-withdrawing group or two or more electron-withdrawing groups may be bonded to the hetero atom.

The halogen atom in the halogen-containing polymer is not particularly limited, and examples thereof include fluorine, chlorine, bromine, and iodine atoms. Preferred among these is a fluorine atom. Containing a fluorine atom, the halogen-containing polymer is more easily dissolved in an organic solvent, facilitating formation of a hole transport layer. In addition, containing a fluorine atom, the compatibility with the organic semiconductor component (1) described later is enhanced to improve the photoelectric conversion efficiency.

At least one halogen atom is preferably bonded to the electron-withdrawing group or α-position of the electron-withdrawing group. With such a structure, the compatibility with the organic semiconductor component (1) described later is enhanced to improve the photoelectric conversion efficiency.

The halogen-containing polymer preferably has a conjugated cyclic skeleton through the electron-withdrawing group. When the halogen-containing polymer has a conjugated cyclic skeleton through an electron-withdrawing group, the acidity of the hetero atom increases to increase the carrier density of the hole transport layer, further improving the photoelectric conversion efficiency.

The halogen-containing polymer has a structure of the formula (X) containing a halogen atom and electron-withdrawing groups each bonded to a hetero atom.

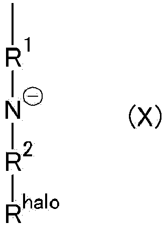

In the formula (X), R¹ and R² are each an electron-withdrawing group and R^{halo} is a group containing a halogen atom. R¹ and R² may be the same as or different from each other.[

In the formula (X), the electron-withdrawing groups represented by R¹ and R² are not particularly limited, and examples thereof include sulfonyl, sulfide, sulfinyl, thioester, thioketone, ester, ether, carbonyl, amide, and urethane groups. Any of these electron-withdrawing groups may be used alone or two or more types thereof may be used in combination. More preferred among these is a sulfonyl group.

In the formula (X), the group containing a halogen atom represented by R^{halo} is not particularly limited, provided that it contains a halogen atom as described above. Preferably, the group contains a fluorine atom. When the group contains a fluorine atom, the halogen-containing polymer is more easily dissolved in an organic solvent, further facilitating formation of a hole transport layer. Moreover, when the group contains a fluorine atom, the compatibility with the organic semiconductor component (1) described later is enhanced to improve the photoelectric conversion efficiency.

The group containing a fluorine atom is not particularly limited, and is preferably an alkyl or aryl group in which hydrogen atoms are partly or entirely substituted by fluorine atoms.

In the formula (X), the group containing a halogen atom represented by R^{halo} is preferably a halogen atom or an alkyl or aryl group in which hydrogen atoms are partly or entirely substituted by fluorine atoms.

The halogen-containing polymer is a polymer. Being a polymer, the halogen-containing polymer is not likely to be precipitated or segregated even when the compound concentration increases, leading to improvement of the photoelectric conversion efficiency and high-temperature, high-humidity durability.

The polymer as used herein refers to a compound in which the number of repeating units of a monomer constituting the polymer is two or more.

The degree of polymerization of the halogen-containing polymer is 2 or more, preferably 10 or more, more preferably 100 or more. The upper limit of the degree of polymerization of the halogen-containing polymer is not particularly limited. The degree of polymerization of the halogen-containing polymer is preferably 10,000 or less for excellent solubility in an organic solvent and facilitation of the formation of a hole transport layer.

The degree of polymerization as used herein refers to a value obtained by dividing the molecular weight of the polymer by the molecular weight of the monomer. The molecular weight refers to a weight average molecular weight and can be obtained by the measurement by gel permeation chromatography (GPC), followed by conversion of the obtained value into a polystyrene-equivalent value. Examples of the column used for the measurement of the weight average molecular weight in terms of polystyrene by GPC include HSPgel RT MB-M (available from Waters Corporation). Examples of the solvent used in GPC include dimethyl sulfoxide.

The monomer constituting the halogen-containing polymer is not particularly limited, and examples thereof include styrene derivatives, (meth)acrylic acid esters, vinyl ether, and (meth)acrylamide.

Examples of the halogen-containing polymer include polymers having a structural unit of the following formula (1) .

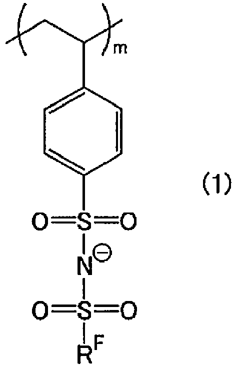

In the formula (1), R^{F} is a halogen atom or an alkyl or aryl group in which hydrogen atoms are partly or entirely substituted by fluorine atoms, and m is an integer of 2 or more.

In the polymer having a structural unit of the formula (1), not all the structural units are required to be the structural unit of the formula (1). The polymer having a structural unit of the formula (1) may contain a different structural unit, provided that it contains a structural unit of the formula (1).

The different structural unit is not particularly limited, and examples thereof include structural units derived from styrene derivatives, (meth)acrylic acid esters, vinyl ether, (meth)acrylamide, and the like.

Examples of a method for synthesizing a halogen-containing polymer having a structure that contains a fluorine atom and an electron-withdrawing group bonded to a hetero atom, among the halogen-containing polymers, include a method of polymerizing a monomer having a structure that contains a fluorine atom and an electron-withdrawing group bonded to a hetero atom, and a method of polymerizing a monomer containing neither a fluorine atom nor a structure that contains an electron-withdrawing group bonded to a hetero atom and then adding a fluorine atom and a structure that contains an electron-withdrawing group bonded to a hetero atom by a chemical reaction.

The lower limit of the amount of the halogen-containing polymer in the hole transport layer is preferably 1% by weight, and the upper limit thereof is preferably 99% by weight. When the amount is within this range, the solar cell can exhibit especially high photoelectric conversion efficiency and excellent high-temperature, high-humidity durability. The lower limit of the amount is more preferably 5% by weight and the upper limit thereof is more preferably 75% by weight. The lower limit is still more preferably 10% by weight and the upper limit is still more preferably 50% by weight.

The organic semiconductor component (1) is not particularly limited, and examples thereof include polytriarylamine, spirobifluorene, phthalocyanine, naphthalocyanine, polythiophene, porphyrin, and derivatives of these. In terms of film-forming properties, preferred are spirobifluorene, polytriarylamine, and polythiophene.

The organic semiconductor component (1) preferably contains a hetero atom. When the organic semiconductor component (1) contains a hetero atom, the photoelectric conversion efficiency and high-temperature, high-humidity durability of the solar cell can be improved.

In the hole transport layer, the lower limit of the amount of the organic semiconductor component (1) is preferably 1% by weight, and the upper limit thereof is preferably 99% by weight. When the amount is within this range, the photoelectric conversion efficiency can be further improved. The lower limit of the amount is more preferably 25% by weight and the upper limit thereof is more preferably 95% by weight. The lower limit is still more preferably 50% by weight and the upper limit is still more preferably 90% by weight.

In the hole transport layer, the lower limit of the doping rate of the halogen-containing polymer relative to the organic semiconductor (1) (proportion of the valence of the halogen-containing polymer to the valence of the organic semiconductor component (1)) is preferably 1%, and the upper limit thereof is preferably 100%. When the doping rate is within this range, the solar cell can exhibit especially high photoelectric conversion efficiency and excellent high-temperature, high-humidity durability. The lower limit of the doping rate is more preferably 5%, and the upper limit thereof is more preferably 75%. The lower limit is still more preferably 10%, and the upper limit is still more preferably 50%.

The hole transport layer has a metallic concentration of preferably 1,000 ppm or lower. With such a metallic concentration, the solar cell can exhibit still higher photoelectric conversion efficiency. The upper limit of the metallic concentration is more preferably 100 ppm, still more preferably 10 ppm.

The lower limit of the thickness of the hole transport layer is preferably 1 nm, and the upper limit thereof is preferably 2,000 nm. With a thickness of 1 nm or more, the hole transport layer can sufficiently block electrons. With a thickness of 2,000 nm or less, the hole transport layer is less likely to be the resistance to the hole transport, enhancing the photoelectric conversion efficiency. The lower limit of the thickness of the hole transport layer is more preferably 3 nm, and the upper limit thereof is more preferably 1,000 nm. The lower limit is still more preferably 5 nm and the upper limit is still more preferably 500 nm.

Next, the solar cell of the second aspect of the present invention is described.

The solar cell of the second aspect of the present invention has at least a photoelectric conversion layer, a hole transport layer, and an anode.

The hole transport layer is disposed between the photoelectric conversion layer and the anode.

The hole transport layer contains an organic semiconductor component (2). The organic semiconductor component (2) has a structure that contains a halogen atom and an electron-withdrawing group bonded to a hetero atom. Having such a hole transport layer, the solar cell of the second aspect of the present invention can exhibit high photoelectric conversion efficiency and excellent high-temperature, high-humidity durability. Though being not clear, the reason for this is presumably that the use of an organic semiconductor component (2) provided with the properties of the above halogen-containing polymer avoids precipitation or segregation of a dopant during formation of a hole transport layer. In addition, since the organic semiconductor component (2) contains a halogen atom and is soluble in an organic solvent, the effect of facilitating the formation of a hole transport layer can be achieved.

The organic semiconductor component (2) may be in the form of ions (anion, cation) or the form of a salt as long as it has a structure that contains a halogen atom and an electron-withdrawing group bonded to a hetero atom.

The hetero atom is a nitrogen atom for better compatibility with the basic structure of the organic semiconductor component (2).

The electron-withdrawing group in the organic semiconductor component (2) is not particularly limited, and examples thereof include sulfonyl, sulfide, thioester, thioketone, ester, ether, carbonyl, amide, urethane, sulfinyl, and phosphonyl groups. Any of these electron-withdrawing groups may be used alone or two or more types thereof may be used in combination. One electron-withdrawing group or two or more electron-withdrawing groups may be bonded to the hetero atom.

The halogen atom in the organic semiconductor component (2) is not particularly limited, and examples thereof include fluorine, chlorine, bromine, and iodine atoms. Preferred among these is a fluorine atom. Containing a fluorine atom, the organic semiconductor component (2) is more easily dissolved in an organic solvent, facilitating formation of a hole transport layer. In addition, since a fluorine atom is compatible with the basic structure of the organic semiconductor component (2), the organic semiconductor component (2) containing a fluorine atom can improve the photoelectric conversion efficiency.

At least one halogen atom is preferably bonded to the electron-withdrawing group or α-position of the electron-withdrawing group. Since such a configuration is compatible with the basic structure of the organic semiconductor component (2), the photoelectric conversion efficiency can be improved.

The organic semiconductor component (2) preferably has a conjugated cyclic skeleton through the electron-withdrawing group. When the organic semiconductor component (2) has a conjugated cyclic skeleton through the electron-withdrawing group, the acidity of the hetero atom increases to increase the carrier density of the hole transport layer, thereby further improving the photoelectric conversion efficiency.

The organic semiconductor component (2) has a structure of the formula (X) containing a halogen atom and electron-withdrawing groups bonded to a hetero atom.

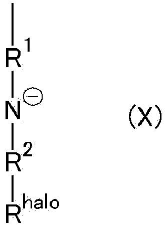

In the formula (X), R¹ and R² are each an electron-withdrawing group and R^{halo} is a group containing a halogen atom. R¹ and R² may be the same as or different from each other.

The electron-withdrawing groups represented by R¹ and R² in the formula (X) are not particularly limited, and are preferably sulfonyl, sulfide, sulfinyl, thioester, thioketone, ester, ether, carbonyl, amide, or urethane groups. Any of these electron-withdrawing groups may be used alone or two or more thereof may be used in combination. The electron-withdrawing groups are more preferably sulfonyl groups.

The group containing a halogen atom represented by R^{halo} in the formula (X) is not particularly limited, and is only required to contain the above-mentioned halogen atom. Preferably, the group containing a halogen atom contains a fluorine atom. Containing a fluorine atom, the organic semiconductor component (2) is more easily dissolved in an organic solvent to further facilitate formation of a hole transport layer. In addition, containing a fluorine atom, the group containing a halogen atom is more compatible with the basic structure of the organic semiconductor component (2) to improve the photoelectric conversion efficiency.

The group containing a fluorine atom is not particularly limited. Preferred is an alkyl or aryl group in which hydrogen atoms are partly or entirely substituted by fluorine atoms.

In the formula (X), the group containing a halogen atom represented by R^{halo} is preferably a halogen atom or an alkyl or aryl group in which hydrogen atoms are partly or entirely substituted by fluorine atoms.

The organic semiconductor component (2) may or may not be a polymer. In the case of a polymer, the organic semiconductor component (2) has a degree of polymerization of 2 or more, preferably 10 or more, more preferably 100 or more. The upper limit of the degree of polymerization of the organic semiconductor component (2) is not particularly limited. For excellent solubility of the organic semiconductor component (2) in an organic solvent and facilitation of formation of a hole transport layer, the degree of polymerization of the organic semiconductor component (2) is preferably 10,000 or less.

The basic structure of the organic semiconductor component (2) is not particularly limited, and examples thereof include polytriarylamine, spirobifluorene, phthalocyanine, naphthalocyanine, polythiophene, porphyrin, and derivatives of these. Among these, preferred are polytriarylamine and phthalocyanine, and more preferred is polytriarylamine for excellent solubility of the organic semiconductor component (2) in an organic solvent and facilitation of formation of a hole transport layer.

The basic structure of the organic semiconductor component (2) preferably contains a hetero atom. When the basic structure of the organic semiconductor component (2) contains a hetero atom, the photoelectric conversion efficiency and high-temperature, high-humidity durability of the solar cell can be improved.

Specific examples of the organic semiconductor component (2) include polytriarylamine having a structural unit represented by the following formula (2) and phthalocyanine represented by the following formula (3).

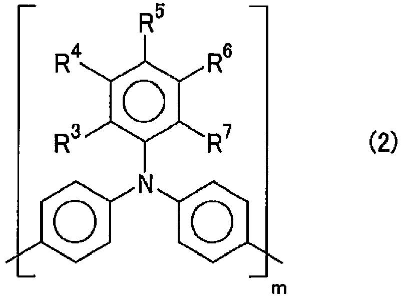

In the formula (2), at least one of R³ to R⁷ is a substituent having a structure of the formula (X) containing a halogen atom and electron-withdrawing groups bonded to a hetero atom, and m is an integer of 2 or more.

At least one of R³ to R⁷ in the formula (2) is a substituent having a structure of the formula (X). R³ to R⁷ may be the same as or different from one another. Among R³ to R⁷, the substituent other than the substituent having a structure of the formula (X) is not particularly limited. Examples thereof include hydrogen, halogen, an alkyl group, an aryl group, and an alkoxy group.

In the polytriarylamine having a structural unit of the formula (2), all the structural units are not required to be the structural units of the formula (2). The polytriarylamine may contain a different structural unit, provided that it contains a structural unit of the formula (2) .

The different structural unit is not particularly limited, and examples thereof include a structural unit derived from common triarylamine with no substituent having a structure of the formula (X).

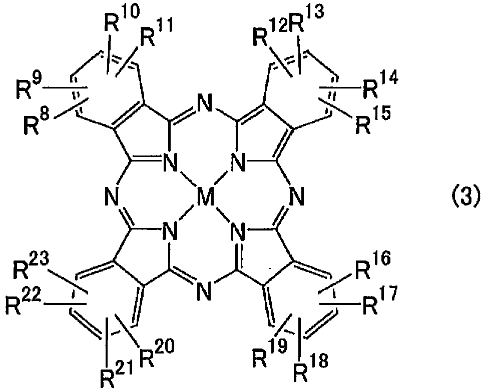

In the formula (3), at least one of R⁸ to R²³ is a substituent having a structure of the formula (X) containing a halogen atom and electron-withdrawing groups bonded to a hetero atom, and M is a metallic element.

At least one of R⁸ to R²³ in the formula (3) is a substituent having a structure of the formula (X). R⁸ to R²³ may be the same as or different from one another. Among R⁸ to R²³, the substituent other than the substituent having a structure of the formula (X) is not particularly limited. Examples thereof include hydrogen, halogen, an alkyl group, an aryl group, and an alkoxy group. The metallic element represented by M is not particularly limited, and examples thereof include copper, zinc, nickel, magnesium, cobalt, and palladium. Preferred among these is copper.

The organic semiconductor component (2) may be synthesized by any method. In the case where the organic semiconductor component (2) is a polymer, examples of the method include a method of polymerizing a monomer having a structure that contains a halogen atom and an electron-withdrawing group bonded to a hetero atom optionally together with a different monomer, and a method of polymerizing a monomer containing neither a halogen atom nor a structure that contains an electron-withdrawing group bonded to a hetero atom and then adding a halogen atom and a structure that contains an electron-withdrawing group bonded to a hetero atom by a chemical reaction.

In the case where the organic semiconductor component (2) is not a polymer, examples of the method include a method of adding a halogen atom and a structure that contains an electron-withdrawing group bonded to a hetero atom to the basic structure of the organic semiconductor component (2) by a chemical reaction.

The lower limit of the doping rate in the organic semiconductor component (2) is preferably 1%, and the upper limit thereof is preferably 100%. With the doping rate within this range, the solar cell can exhibit especially high photoelectric conversion efficiency and excellent high-temperature, high-humidity durability. The lower limit of the doping rate is more preferably 5% and the upper limit thereof is more preferably 75%. The lower limit is still more preferably 10% and the upper limit is still more preferably 50%.

The doping rate in the organic semiconductor component (2) refers to a proportion of the valence of the structure that contains a halogen atom and an electron-withdrawing group bonded to a hetero atom to the valence of the basic structure of the organic semiconductor (2). The doping rate can be calculated by comparing the number of protons of the basic structure of the organic semiconductor (2) and the number of protons of the structure that contains halogen and an electron-withdrawing group bonded to a hetero atom by proton NMR or the like.

The hole transport layer has a metallic concentration of preferably 1,000 ppm or lower. With such a hole transport layer, the solar cell can exhibit still higher photoelectric conversion efficiency. The upper limit of the metallic concentration is more preferably 100 ppm, still more preferably 10 ppm.

The lower limit of the thickness of the hole transport layer is preferably 1 nm, and the upper limit thereof is preferably 2,000 nm. With a thickness of 1 nm or more, the hole transport layer can sufficiently block electrons. With a thickness of 2,000 nm or less, the hole transport layer is less likely to be the resistance to the hole transport, enhancing the photoelectric conversion efficiency. The lower limit of the thickness of the hole transport layer is more preferably 3 nm, and the upper limit thereof is more preferably 1,000 nm. The lower limit is still more preferably 5 nm, and the upper limit is still more preferably 500 nm.

Hereinbelow, a description is given on the matters common to the solar cell of the first aspect of the present invention and the solar cell of the second aspect of the present invention. The first aspect of the present invention and the second aspect of the present invention are simply referred to as the present invention in the description given on the matters common to the solar cell of the first aspect of the present invention and the solar cell of the second aspect of the present invention.

The photoelectric conversion layer in the solar cell of the present invention contains an organic-inorganic perovskite compound represented by the formula: R-M-X₃ (where R is an organic molecule, M is a metal atom, and X is a halogen atom or a chalcogen atom) as organic-inorganic perovskite compound. The solar cell having the photoelectric conversion layer containing the organic-inorganic perovskite compound is also referred to as an organic inorganic hybrid solar cell.

When the photoelectric conversion layer contains the organic-inorganic perovskite compound, the solar cell can have better photoelectric conversion efficiency. Though being not clear, the reason for this is presumably because that the photoelectric conversion layer containing the organic-inorganic perovskite compound is compatible with the hole transport layer containing the organic semiconductor component (1) or (2) at the interface to further reduce charge recombination at the interface between the layers. Since the organic-inorganic perovskite compound has poor humidity resistance, in the case where the photoelectric conversion layer contains the organic-inorganic perovskite compound, it is more effective to dispose a resin layer and an inorganic layer on either one of the cathode and the anode for better durability of the solar cell.

R is an organic molecule and is preferably represented by CₗNₘHₙ (1, m, and n are each a positive integer).

Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, acetoamidine, guanidine, imidazole, azole, pyrrole, aziridine, azirine, azetidine, azete, azole, imidazoline, carbazole, ions of these (e.g., methylammonium (CH₃NH₃)), and phenethylammonium. Preferred among these are methylamine, ethylamine, propylamine, butylamine, pentylamine, hexylamine, formamidine, acetoamidine, ions of these, and phenethylammonium. More preferred are methylamine, ethylamine, propylamine, formamidine, and ions of these.

M is a metal atom, and examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used alone or two or more of these may be used in combination.

X is a halogen atom or a chalcogen atom, and examples thereof include chlorine, bromine, iodine, sulfur, and selenium. These halogen atoms or chalcogen atoms may be used alone or two or more of these may be used in combination. Preferred among these is a halogen atom because the organic-inorganic perovskite compound containing halogen in the structure is soluble in an organic solvent to be usable in an inexpensive printing method or the like. More preferred is iodine because the organic-inorganic perovskite compound has a narrower energy band gap.

The organic-inorganic perovskite compound preferably has a cubic crystal structure where the metal atom M is placed at the body center, the organic molecule R is placed at each vertex, and the halogen atom or chalcogen atom X is placed at each face center.

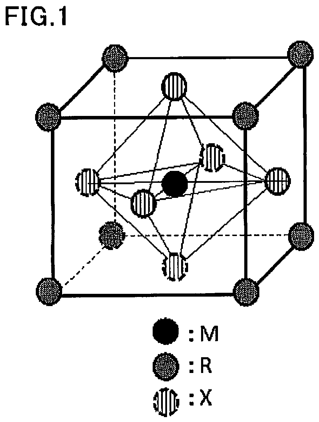

Fig. 1 is a schematic view illustrating an exemplary crystal structure of the organic-inorganic perovskite compound having a cubic crystal structure where the metal atom M is placed at the body center, the organic molecule R is placed at each vertex, and the halogen atom or chalcogen atom X is placed at each face center. Although details are not clear, it is presumed that the direction of an octahedron in the crystal lattice can be easily changed owing to the structure; thus the mobility of electrons in the organic-inorganic perovskite compound is enhanced, improving the photoelectric conversion efficiency of the solar cell.

The organic-inorganic perovskite compound is preferably a crystalline semiconductor. The crystalline semiconductor means a semiconductor whose scattering peak can be detected by the measurement of X-ray scattering intensity distribution. When the organic-inorganic perovskite compound is a crystalline semiconductor, the mobility of electrons in the organic-inorganic perovskite compound is enhanced, improving the photoelectric conversion efficiency of the solar cell.

The degree of crystallinity can also be evaluated as an index of crystallization. The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. When the degree of crystallinity is 30% or more, the mobility of electrons in the organic-inorganic perovskite compound is enhanced, improving the photoelectric conversion efficiency of the solar cell. The lower limit of the degree of crystallinity is more preferably 50%, further preferably 70%.

Examples of the method for increasing the degree of crystallinity of the organic-inorganic perovskite compound include heat annealing, irradiation with light having strong intensity, such as laser, and plasma irradiation.

The lower limit of the thickness of a portion formed of the organic-inorganic perovskite compound is preferably 5 nm, and the upper limit thereof is preferably 5,000 nm. With the thickness of 5 nm or more, the portion can sufficiently absorb light to improve the photoelectric conversion efficiency. With the thickness of 5,000 nm or less, formation of a region in which charge separation cannot be achieved can be suppressed, leading to higher photoelectric conversion efficiency. The lower limit of the thickness is more preferably 10 nm and the upper limit thereof is more preferably 1,000 nm. The lower limit is still more preferably 20 nm and the upper limit is still more preferably 500 nm.

Examples of the method for forming the photoelectric conversion layer include, but are not particularly limited to, a vapor deposition method, a sputtering method, a chemical vapor deposition (CVD) method, an electrochemical deposition method, and a printing method. Among them, employment of a printing method allows simple formation of a large-area solar cell that can exhibit high photoelectric conversion efficiency. Examples of the printing method include a spin coating method and a casting method. Examples of the method using the printing method include a roll-to-roll method.

The material of the anode in the solar cell of the present invention is not particularly limited, and a conventionally known material may be used. The anode is often a patterned electrode.

Examples of the material of the anode include metals such as gold, conductive transparent materials such as CuI, indium tin oxide (ITO), SnO₂, aluminum zinc oxide (AZO), indium zinc oxide (IZO), and gallium zinc oxide (GZO), and conductive transparent polymers. These materials may be used alone or may be used in combination of two or more thereof.

The solar cell of the present invention may have an electron transport layer on the opposite side of the hole transport layer across the photoelectric conversion layer.

Examples of the material of the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylenevinylene, boron-containing polymers, bathocuproine, bathophenanthrene, hydroxyquinolinato aluminum, oxadiazole compounds, benzimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The electron transport layer may consist only of a thin film-like electron transport layer and preferably includes a porous electron transport layer. In particular, when the photoelectric conversion layer is a composite film in which an organic semiconductor or inorganic semiconductor part and an organic-inorganic perovskite compound part are combined, a composite film is preferably formed on a porous electron transport layer because a more complicated composite film (more intricate structure) is obtained, enhancing the photoelectric conversion efficiency.

The lower limit of the thickness of the electron transport layer is preferably 1 nm, and the upper limit thereof is preferably 2,000 nm. With a thickness of 1 nm or more, the electron transport layer can sufficiently block holes. With a thickness of 2,000 nm or less, the electron transport layer is less likely to be the resistance to the electron transport, enhancing the photoelectric conversion efficiency. The lower limit of the thickness of the electron transport layer is more preferably 3 nm and the upper limit thereof is more preferably 1,000 nm. The lower limit is still more preferably 5 nm and the upper limit is still more preferably 500 nm.

The solar cell of the present invention may further have a cathode and the like.

The material of the cathode is not particularly limited, and a conventionally known material may be used. Examples of the material of the cathode include fluorine-doped tin oxide (FTO), sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. These materials may be used alone or may be used in combination of two or more thereof.

The solar cell of the present invention may further have a substrate and the like. Examples of the substrate include, but are not particularly limited to, transparent glass substrates such as soda-lime glass and alkali-free glass substrates, ceramic substrates, and transparent plastic substrates.

The solar cell of the present invention may be produced by any method, and examples of the method include a method of forming, on the substrate, the cathode, the electron transport layer, the photoelectric conversion layer, the hole transport layer, and the anode in the stated order.

### - Advantageous Effects of Invention

The present invention can provide a solar cell having high photoelectric conversion efficiency and excellent high-temperature, high-humidity durability.

### BRIEF DESCRIPTION OF DRAWINGS

Fig. 1 is a schematic view illustrating an exemplary crystal structure of an organic-inorganic perovskite compound.

### DESCRIPTION OF EMBODIMENTS

Hereinafter, the present invention will be described in more detail with reference to Examples. However, the present invention is not intended to be limited by these Examples.

### (Example 1)

### (1) Synthesis of a halogen-containing polymer

An amount of 15 g of p-styrenesulfonic acid and 30 mL of thionyl chloride were reacted in 70 mL of DMF for three hours, followed by liquid separation to obtain styrene sulfonyl chloride. Then, to a solution obtained by adding 0.23 g of dimethylaminopyridine to 13 mL of trimethylamine were added the above obtained styrene sulfonyl chloride and 10 g of trifluoromethanesulfonamide to be reacted, followed by addition of 17 g of silver oxide to obtain a precipitate. Thus, a monomer containing a halogen atom was prepared.

Then, the above-obtained monomer containing a halogen atom was reacted in the presence of azobisisobutyronitrile as a polymerization initiator in an argon atmosphere at 60°C for 18 hours to give a silver salt of a halogen-containing polymer represented by the following formula (m is an integer of 2 or more) which is a compound of the formula (1) where R^{F} is CF₃. In other words, a silver salt of poly(N-styrenesulfonyl-trifluoromethane sulfonimide)(PSTFSI) was obtained.

The weight average molecular weight of the obtained halogen-containing polymer was measured by gel permeation chromatography (GPC) using HSPgel RT MB-M (Waters Corporation) as a column and dimethyl sulfoxide as a solvent, and the degree of polymerization was calculated. The obtained degree of polymerization was 285.

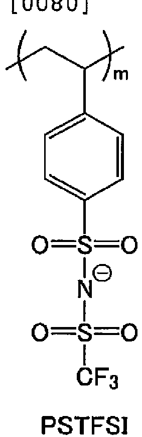

### (2) Production of a solar cell

A FTO film having a thickness of 1,000 nm was formed as a cathode on a glass substrate, ultrasonically washed with pure water, acetone, and methanol each for ten minutes in the stated order, and then dried.

A solution of titanium isopropoxide in ethanol adjusted to 2% was applied to the surface of the FTO film by the spin coating method and then fired at 400°C for 10 minutes to form a thin film-like electron transport layer having a thickness of 20 nm. A titanium oxide paste containing polyisobutyl methacrylate as an organic binder and titanium oxide (mixture of powders having average particle sizes of 10 nm and 30 nm) was further applied to the thin film-like electron transport layer by the spin coating method and then fired at 500°C for 10 minutes to form a porous electron transport layer having a thickness of 500 nm.

Separately, lead iodide was reacted with dimethyl sulfoxide (DMSO) in advance to prepare a lead iodide-dimethyl sulfoxide complex. The lead iodide-dimethyl sulfoxide complex was dissolved in N,N-dimethylformamide (DMF) at a concentration of 40% by weight to prepare a coating solution.

On the electron transport layer was laminated the obtained coating solution by the spin coating method to a thickness of 500 nm, and an 8% solution of methylammonium iodide in isopropanol was applied thereto by the spin coating method so that the coating solution was reacted. A photoelectric conversion layer containing an organic-inorganic perovskite compound was thus formed.

Next, poly[bis(4-phenyl)(2,4,6-trimethylphenyl)amine] (PTAA) as the organic semiconductor component (1) was dissolved in chloroform. Separately, the above-obtained halogen-containing polymer was dissolved in acetone. Here, the organic semiconductor component (1) and the halogen-containing polymer was mixed to a doping rate specified in Table 1, and the precipitated silver was filtered off to prepare a solution for a hole transport layer. The obtained solution was applied to the photoelectric conversion layer by the spin coating method to form a hole transport layer.

On the obtained hole transport layer were formed an ITO film with a thickness of 100 nm as an anode by vacuum deposition. Thus, a solar cell including a cathode, an electron transport layer, a photoelectric conversion layer, a hole transport layer, and an anode in the stack was obtained.

### (Examples 2 to 7)

A solar cell was obtained in the same manner as in Example 1, except that the doping rate of the halogen-containing polymer in the hole transport layer was changed as shown in Table 1.

### (Examples 8 to 10)

A solar cell was obtained in the same manner as in Example 1, except that the type and degree of polymerization of the halogen-containing polymer in the hole transport layer were changed as shown in Table 1.

PSNFSI was a halogen-containing polymer (poly(N-styrenesulfonyl-nonafluorobutanesulfonimide)) obtained in the same manner as in the case of PSTFSI in Example 1, except that trifluoromethane sulfonamide was changed to nonafluorobutanesulfonamide. The degree of polymerization of the halogen-containing polymer was adjusted by known methods such as adjustment of the amount of the initiator and adjustment of the reaction time.

### (Examples 11 to 13)

A solar cell was produced in the same manner as in Example 1, except that the type of the organic semiconductor component (1) in the hole transport layer was changed as shown in Table 1.

The organic semiconductor components (1) abbreviated in Table 1 are listed below.
Spiro-OMeTAD: N2,N2,N2',N2',N7,N7,N7',N7'-octakis(4-methoxyphenyl)-9,9'-spirobi[9H-fluorene]-2,2',7,7'-tetraamine
P3HT: poly(3-hexylthiophene-2,5-diyl)
Phthalocyanine: phthalocyanine copper complex

### (Examples 14 to 18)

A solar cell was produced in the same manner as in Example 1, except that the type and degree of polymerization of the halogen-containing polymer in the hole transport layer were changed as shown in Table 1.

PSTFCI was a halogen-containing polymer represented by the following formula (m is an integer of 2 or more) obtained in the same manner as in the case of PSTFSI in Example 1, except that p-styrenesulfonic acid was changed to 4-vinylbenzoic acid and trifluoromethane sulfonamide was changed to trifluoroacetamide.

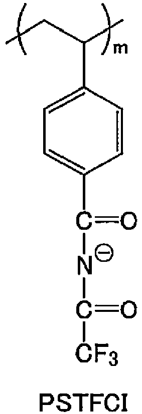

PSTClSI was a halogen-containing polymer of the following formula (m is an integer of 2 or more) obtained in the same manner as in the case of PSTFSI in Example 1, except that trifluoromethane sulfonamide was changed to trichloromethane sulfonamide.

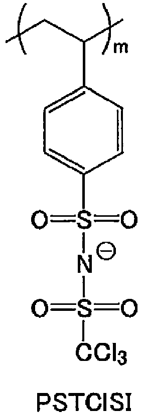

PATFSI was a halogen-containing polymer of the following formula (m is an integer of 2 or more) obtained in the same manner as in the case of PSTFSI in Example 1, except that p-styrenesulfonic acid was changed to allylsulfonic acid.

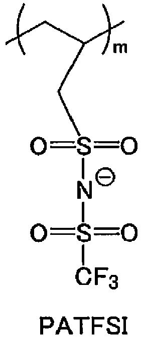

PTFMA was a halogen-containing polymer of the following formula (m is an integer of 2 or more) obtained using 2-(trifluoromethyl)acrylic acid as a monomer containing a halogen atom in the same manner as in the case of PSTFSI in Example 1.

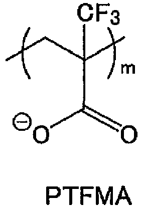

PDFPA was a halogen-containing polymer of the following formula (m is an integer of 2 or more) obtained in the same manner as in the case of PSTFSI in Example 1 using 2,2-difluoropent-4-enoic acid as a monomer containing a halogen atom.

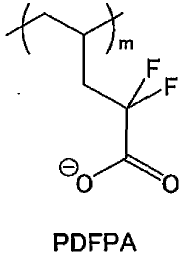

### (Comparative Examples 1 to 7)

A solar cell was obtained in the same manner as in Example 1, except that the type of the organic semiconductor component (1) in the hole transport layer, the type and doping rate of a different dopant used instead of the halogen-containing polymer were changed as shown in Table 1.

Different dopants abbreviated in Table 1 are listed below.
TFSI: trifluoromethanesulfonimide
STFSI: N-styrenesulfonyl-trifluoromethanesulfonimide
NFSI: nonafluorobutanesulfonimide
PSS: polystyrene sulfonate

PSMSI was a polymer of the following formula (m is an integer of 2 or more) not containing halogen, obtained in the same manner as in the case of PSTFSI in Example 1, except that trifluoromethane sulfonamide was changed to methane sulfonamide.

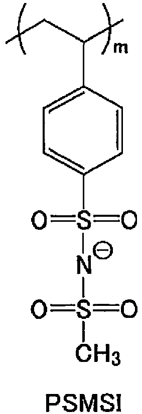

### (Example 19)

### (1) Synthesis of an organic semiconductor component (2)

An amount of 18.5 g of 4-propanesulfonic acid-2,6-dimethylaniline and 30 mL of thionyl chloride were reacted in 70 mL of DMF for three hours, followed by liquid separation to obtain 4-propanesulfonyl chloride-2,6-dimethylaniline. Then, 13.6 g of the obtained 4-propanesulfonyl chloride-2,6-dimethylaniline and 19 g of 2,4,6-trimethylaniline were dissolved in 100 mL of mesitylene. To the solution were added 3 g of 18-crown-6, 1.4 g of potassium carbonate, and 0.4 g of copper, followed by reaction at 140°C for 72 hours. The obtained reaction product was reprecipitated in methanol to obtain a polymer. To 100 mL of acetonitrile were added 13 mL of triethylamine and 0.23 g of dimethylaminopyridine to prepare a solution. An amount of 30 g of the above-obtained polymer and 10 g of trifluoromethane sulfonamide were added to the obtained solution and reacted to obtain an organic semiconductor component (2) (PTAA-TFSI) having a structure of the following formula (m is an integer of 2 or more) in which TFSI was added to PTAA.

The number of protons of PTAA and the number of protons of the structure that contains halogen and an electron-withdrawing group bonded to a hetero atom in the organic semiconductor component (2) were compared by proton NMR, and the doping rate was calculated. The obtained doping rate was 30%.

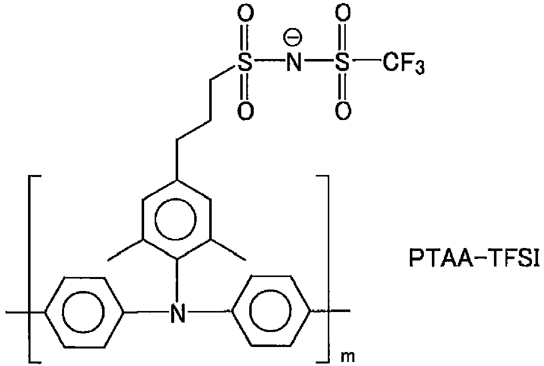

### (2) Production of a solar cell

A FTO film having a thickness of 1,000 nm was formed as a cathode on a glass substrate, ultrasonically washed with pure water, acetone, and methanol each for ten minutes in the stated order, and then dried.

A solution of titanium isopropoxide in ethanol adjusted to 2% was applied to the surface of the FTO film by the spin coating method and then fired at 400°C for 10 minutes to form a thin film-like electron transport layer having a thickness of 20 nm. A titanium oxide paste containing polyisobutyl methacrylate as an organic binder and titanium oxide (mixture of powders having average particle sizes of 10 nm and 30 nm) was further applied to the thin film-like electron transport layer by the spin coating method and then fired at 500°C for 10 minutes to form a porous electron transport layer having a thickness of 500 nm.

Separately, lead iodide was reacted with dimethyl sulfoxide (DMSO) in advance to prepare a lead iodide-dimethyl sulfoxide complex. The lead iodide-dimethyl sulfoxide complex was dissolved in N,N-dimethylformamide (DMF) at a concentration of 40% by weight to prepare a coating solution.

On the electron transport layer was laminated the obtained coating solution by the spin coating method to a thickness of 500 nm, and a 8% solution of methyl ammonium iodide in isopropanol was applied thereto by the spin coating method so that the coating solution was reacted. A photoelectric conversion layer containing an organic-inorganic perovskite compound was thus formed.

Next, PTAA-TFSI as the organic semiconductor component (2) was dissolved in chloroform to prepare a solution for a hole transport layer. The obtained solution was applied to the photoelectric conversion layer by the spin coating method to form a hole transport layer.

On the obtained hole transport layer were formed an ITO film with a thickness of 100 nm as an anode by vacuum deposition. Thus, a solar cell including a cathode, an electron transport layer, a photoelectric conversion layer, a hole transport layer, and an anode stacked on each other was obtained.

### (Examples 20 to 25)

A solar cell was obtained in the same manner as in Example 19, except that the doping rate in the organic semiconductor component (2) in the hole transport layer was changed as shown in Table 1.

### (Examples 26 to 29)

A solar cell was obtained in the same manner as in Example 19, except that the type and doping rate in the organic semiconductor component (2) in the hole transport layer were changed as shown in Table 1.

PTAA-NFSI was the organic semiconductor component (2) prepared in the same manner as in the case of PTAA-TFSI in Example 18, except that trifluoromethane sulfonamide was changed to nonafluorobutane sulfonamide.

Phthalocyanine-TFSI was the organic semiconductor component (2) having a structure of a TFSI-added phthalocyanine copper complex of the following formula which was prepared by adding TFSI in the same manner as in the case of PSTFSI in Example 1, except that p-styrene sulfonic acid was changed to phthalocyanine tetrasulfonic acid.

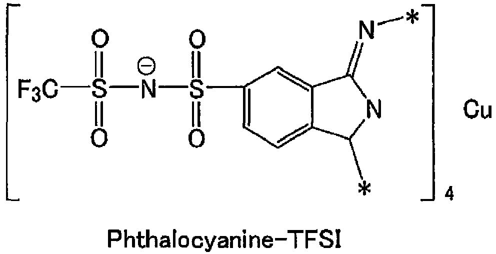

PTAA-TFCI was the organic semiconductor component (2) prepared in the same manner as in the case of PTAA-TFSI in Example 18, except that 4-propanesulfonic acid-2,6-dimethylaniline was changed to 4-butyric acid-2,6-dimethylaniline and trifluoromethane sulfonamide was changed to trifluoroacetamide.

PTAA-TClSI was the organic semiconductor component (2) prepared in the same manner as in the case of PTAA-TFSI in Example 18, except that trifluoromethane sulfonamide was changed to trichloromethane sulfonamide.

### (Comparative Example 8)

A solar cell was obtained in the same manner as in Example 1, except that the type and doping rate in a different organic semiconductor used instead of the organic semiconductor component (2) in the hole transport layer were set as shown in Table 1.

PTAA-MSI was an organic semiconductor component containing no halogen atoms prepared in the same manner as in the case of PTAA-TFSI in Example 18, except that trifluoromethane sulfonamide was changed to methane sulfonamide.

### <Evaluation>

The solar cells obtained in the examples and comparative examples were evaluated for the following parameters. Table 1 shows the results.

### (1) Photoelectric conversion efficiency

A power source (236 model, available from Keithley Instruments Inc.) was connected between the electrodes of the solar cell. The photoelectric conversion efficiency was measured using a solar simulator (available from Yamashita Denso Corp.) having an intensity of 100 mW/cm², and the obtained value was taken as the initial conversion efficiency. The obtained values were normalized based on the initial conversion efficiency of the solar cell obtained in Comparative Example 1 as the standard.
○○ (Excellent): The value of the normalized photoelectric conversion efficiency was 0.9 or more.
○ (Good): The value of the normalized photoelectric conversion efficiency was 0.8 or more and less than 0.9.
× (Poor): The value of the normalized photoelectric conversion efficiency was less than 0.8.

### (2) High-temperature, high-humidity durability

The solar cell was left in an environment at a temperature of 85°C and a humidity of 85% for 1,000 hours to carry out a high-temperature, high-humidity durability test. A power source (236 model, available from Keithley Instruments Inc.) was connected between the electrodes of the solar cell after the high-temperature, high-humidity durability test, and the photoelectric conversion efficiency was measured using a solar simulator (available from Yamashita Denso Corp.) having an intensity of 100 mW/cm². The value of (the photoelectric conversion efficiency after the high-temperature, high-humidity durability test)/ (the initial conversion efficiency obtained above) was calculated.
○○ (Excellent): The value of (the photoelectric conversion efficiency after the high-temperature, high-humidity durability test)/ (the initial conversion efficiency) was 0.9 or more.
○ (Good): The value of (the photoelectric conversion efficiency after the high-temperature, high-humidity durability test)/ (the initial conversion efficiency) was 0.8 or more and less than 0.9.
Δ (Acceptable): The value of (the photoelectric conversion efficiency after the high-temperature, high-humidity durability test)/ (the initial conversion efficiency) was 0.6 or more and less than 0.8.
× (Poor): The value of (the photoelectric conversion efficiency after the high-temperature, high-humidity durability test)/ (the initial conversion efficiency) was less than 0.6.

**[Table 1]**

| | Organic semiconductor (1) | Organic semiconductor (2) | Different organic semiconductor | Halogen-containing polymer | Different dopant | Degree of polymerization of dopant | Doping rate (%) | Evaluation | |
|---|---|---|---|---|---|---|---|---|---|
| | | | | | | | | Conversion efficiency | Durability |
| Example 1 | PTAA | - | - | PSTFSI | - | 285 | 30 | ○○ | ○○ |
| Example 2 | PTAA | - | - | PSTFSI | - | 395 | 1 | ○ | Δ |
| Example 3 | PTAA | - | - | PSTFSI | - | 285 | 5 | ○ | ○ |
| Example 4 | PTAA | - | - | PSTFSI | - | 285 | 10 | ○ | ○○ |
| Example 5 | PTAA | - | - | PSTFSI | - | 285 | 50 | ○○ | ○○ |
| Example 6 | PTAA | - | - | PSTFSI | - | 285 | 75 | ○○ | ○ |
| Example 7 | PTAA | - | - | PSTFSI | - | 285 | 100 | ○○ | Δ |
| Example 8 | PTAA | - | - | PSTFSI | - | 45 | 30 | ○○ | ○ |
| Example 9 | PTAA | - | - | PSTFSI | - | 5 | 30 | ○ | Δ |
| Example 10 | PTAA | - | - | PSNFSI | - | 140 | 30 | ○○ | ○○ |
| Example 11 | Spiro-OMeTAD | - | - | PSTFSI | - | 285 | 30 | ○○ | ○○ |
| Example 12 | Example P3HT | - | - | PSTFSI | - | 285 | 30 | ○○ | ○○ |
| Example 13 | Phthalocyanine | - | - | PSTFSI | - | 285 | 30 | ○ | ○○ |
| Example 14 | PTAA | - | - | PSTFCI | - | 160 | 30 | ○○ | ○○ |
| Example 15 | PTAA | - | - | PSTCISI | - | 110 | 30 | ○ | ○○ |
| Example 16 | PTAA | - | - | PATFSI | - | 220 | 30 | ○ | ○○ |
| Example 17 | PTAA | - | - | PTFMA | - | 250 | 30 | ○ | ○ |
| Example 18 | PTAA | - | - | PDFPA | - | 245 | 30 | ○ | ○○ |
| Comparative Example 1 | PTAA | - | - | - | TFSI | - | 10 | - | × |
| Comparative Example 2 | PTAA | - | - | - | TFSI | - | 50 | × | × |
| Comparative Exemple 3 | PTAA | - | - | - | STFSI | - | 10 | ○○ | × |
| Comparative Example 4 | PTAA | - | - | - | NFSt | - | 10 | ○○ | × |
| Comparative Example 5 | Spiro-OMeTAD | - | - | - | TFSI | - | 10 | ○○ | × |
| Comparative Example 6 | PTAA | - | - | - | PSS | - | 10 | × | ○ |
| Comparative Example 7 | PTAA | - | - | - | PSMSI | 150 | 30 | × | ○ |
| Example 19 | - | PTAA-TFSI | - | - | - | - | 30 | ○○ | ○○ |
| Example 20 | - | PTAA-TFSI | - | - | - | - | 1 | ○ | Δ |
| Example 21 | - | PTAA-TFSI | - | - | - | - | 5 | ○ | ○ |
| Example 22 | - | PTAA-TFSI | - | - | - | - | 10 | ○ | ○○ |
| Example 23 | - | PTAA-TFSI | - | - | - | - | 50 | ○○ | ○○ |
| Example 24 | - | PTAA-TFSI | - | - | - | - | 75 | ○○ | ○ |
| Example 25 | - - | PTAA-TFSI | - | - | - | - | 100 | ○○ | Δ |
| Example 26 | - | PTAA-NFSI | - | - | - | - | 30 | ○○ | ○○ |
| Example 27 | - | Phthalocyanine-TFSI | - | - | - | - | 30 | ○○ | ○○ |
| Example 28 | - | PTAA-TFCI | - | - | - | - | 30 | ○○ | ○○ |
| Example 29 | - | PTAA-TCISI | - | - | - | - | 30 | ○ | ○○ |
| Comparative Example 8 | - | - | PTAA-MSI | - | - | - | 30 | × | ○ |

### INDUSTRIAL APPLICABILITY

The present invention can provide a solar cell having high photoelectric conversion efficiency and excellent high-temperature, high-humidity durability.

## Claims

1. A solar cell comprising at least:
a photoelectric conversion layer;
a hole transport layer; and
an anode,
the hole transport layer being disposed between the photoelectric conversion layer and the anode,
the hole transport layer containing a polymer containing a halogen atom and an organic semiconductor component (1),
the polymer containing a halogen atom having a structure that contains a halogen atom and an electron-withdrawing group bonded to a hetero atom,
wherein the photoelectric conversion layer contains an organic-inorganic perovskite compound of the formula: R-M-X₃ where R is an organic molecule, M is a metal atom, and X is a halogen atom or a chalcogen atom, and
wherein the polymer has a structure of the formula (X) containing a halogen atom and electron-withdrawing groups each bonded to a hetero atom: 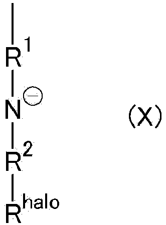
where R¹ and R² may be the same as or different from each other and each represent an electron-withdrawing group and R^{halo} represents a group containing a halogen atom.

2. The solar cell according to claim 1,
wherein the electron-withdrawing groups represented by R¹ and R² in the formula (X) are each a sulfonyl group, a sulfide group, a sulfinyl group, a thioester group, a thioketone group, an ester group, an ether group, a carbonyl group, an amide group, or an urethane group.

3. The solar cell according to claim 2,
wherein the electron-withdrawing groups represented by R¹ and R² in the formula (X) are each a sulfonyl group.

4. The solar cell according to claim 1, 2, or 3,
wherein the group containing a halogen atom represented by R^{halo} in the formula (X) is a halogen atom or an alkyl or aryl group in which hydrogen atoms are partly or entirely substituted by fluorine atoms.

5. The solar cell according to claim 1, 2, 3, or 4,
wherein the polymer containing a halogen atom is a polymer having a structural unit of the formula (1): 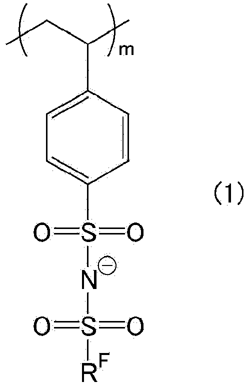 where R^{F} is a halogen atom or an alkyl or aryl group in which hydrogen atoms are partly or entirely substituted by fluorine atoms, and m is an integer of 2 or greater.

6. The solar cell according to claim 1, 2, 3, 4, or 5,
wherein the hole transport layer has a metallic concentration of 1,000 ppm or lower.

7. A solar cell comprising at least:
a photoelectric conversion layer;
a hole transport layer; and
an anode,
the hole transport layer being disposed between the photoelectric conversion layer and the anode,
the hole transport layer containing an organic semiconductor component (2),
the organic semiconductor component (2) having a structure that contains a halogen atom and an electron-withdrawing group bonded to a hetero atom,
wherein the photoelectric conversion layer contains an organic-inorganic perovskite compound of the formula: R-M-X₃ where R is an organic molecule, M is a metal atom, and X is a halogen atom or a chalcogen atom, and
wherein the organic semiconductor component (2) has a structure of the formula (X) containing a halogen atom and electron-withdrawing groups each bonded to a hetero atom: 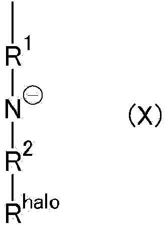 where R¹ and R² may be the same as or different from each other and each represent an electron-withdrawing group, and R^{halo} represents a group containing a halogen atom.

8. The solar cell according to claim 7,
wherein the electron-withdrawing groups represented by R¹ and R² in the formula (X) are each a sulfonyl group, a sulfide group, a sulfinyl group, a thioester group, a thioketone group, an ester group, an ether group, a carbonyl group, an amide group, or an urethane group.

9. The solar cell according to claim 8,
wherein the electron-withdrawing groups represented by R¹ and R² in the formula (X) are each a sulfonyl group.

10. The solar cell according to claim 7, 8, or 9,
wherein the group containing a halogen atom represented by R^{halo} in the formula (X) is a halogen atom or an alkyl or aryl group in which hydrogen atoms are partly or entirely substituted by fluorine atoms.

11. The solar cell according to claim 7, 8, 9, or 10,
wherein the organic semiconductor component (2) is polytriarylamine having a structural unit of the formula (2) or phthalocyanine of the formula (3): 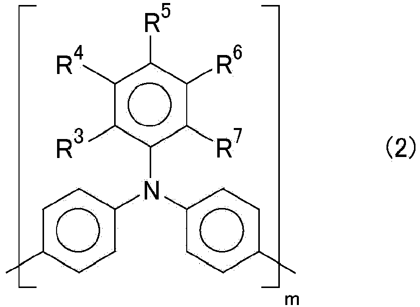 where at least one of R³ to R⁷ represents a substituent having a structure of the formula (X) containing a halogen atom and electron-withdrawing groups each bonded to a hetero atom, and m is an integer of 2 or greater; 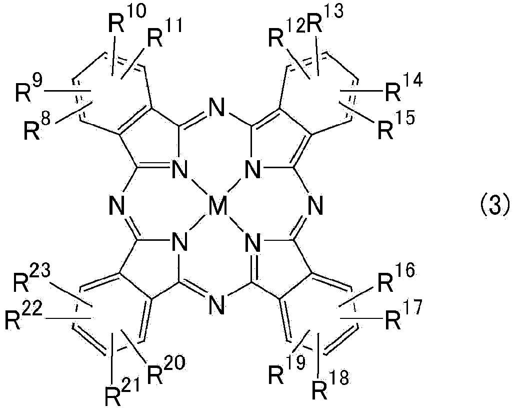 where at least one of R⁸ to R²³ represents a substituent having a structure of the formula (X) containing a halogen atom and electron-withdrawing groups each bonded to a hetero atom, and M is a metallic element.

## Patentansprüche

1. Solarzelle, umfassend wenigstens:
eine photoelektrische Umwandlungsschicht,
eine Lochtransportschicht und
eine Anode,
wobei die Lochtransportschicht zwischen der photoelektrischen Umwandlungsschicht und der Anode angeordnet ist,
wobei die Lochtransportschicht ein Polymer enthält, das ein Halogenatom und ein organisches Halbleiterelement (1) enthält,
wobei das Polymer, das ein Halogenatom enthält, eine Struktur aufweist, die ein Halogenatom und eine an ein Heteroatom gebundene elektronenziehende Gruppe enthält,
wobei die photoelektrische Umwandlungsschicht eine organisch-anorganische Perowskitverbindung der Formel R-M-X₃ enthält, wobei R ein organisches Molekül ist, M ein Metallatom ist und X ein Halogenatom oder ein Chalkogenatom ist, und
wobei das Polymer eine Struktur der Formel (X) aufweist, die ein Halogenatom und elektronenziehende Gruppen enthält, die jeweils an ein Heteroatom gebunden sind: 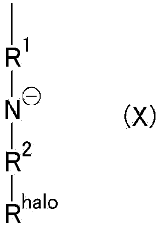 wobei R¹ und R² gleich oder verschieden voneinander sein können und jeweils für eine elektronenziehende Gruppe stehen, und R^{halo} für eine ein Halogenatom enthaltende Gruppe steht.

2. Solarzelle nach Anspruch 1,
wobei die elektronenziehenden Gruppen, für die R¹ und R² in der Formel (X) stehen, jeweils eine Sulfonylgruppe, eine Sulfidgruppe, eine Sulfinylgruppe, eine Thioestergruppe, eine Thioketongruppe, eine Estergruppe, eine Ethergruppe, eine Carbonylgruppe, eine Amidgruppe oder eine Urethangruppe sind.

3. Solarzelle nach Anspruch 2,
wobei die elektronenziehenden Gruppen, für die R¹ und R² in der Formel (X) stehen, jeweils eine Sulfonylgruppe sind.

4. Solarzelle nach Anspruch 1, 2 oder 3,
wobei die ein Halogenatom enthaltende Gruppe, für die R^{halo} in der Formel (X) steht, ein Halogenatom oder eine Alkyl- oder Arylgruppe ist, in der Wasserstoffatome teilweise oder vollständig durch Fluoratome substituiert sind.

5. Solarzelle nach Anspruch 1, 2, 3 oder 4,
wobei das Polymer, das ein Halogenatom enthält, ein Polymer mit einer Struktureinheit der Formel (1) ist: 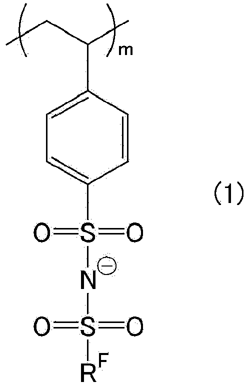 wobei R^{F} ein Halogenatom oder eine Alkyl- oder Arylgruppe ist, in der Wasserstoffatome teilweise oder vollständig durch Fluoratome substituiert sind, und m eine ganze Zahl von 2 oder größer ist.

6. Solarzelle nach Anspruch 1, 2, 3, 4 oder 5,
wobei die Lochtransportschicht eine Metallkonzentration von 1.000 ppm oder weniger aufweist.

7. Solarzelle, umfassend wenigstens:
eine photoelektrische Umwandlungsschicht,
eine Lochtransportschicht und
eine Anode,
wobei die Lochtransportschicht zwischen der photoelektrischen Umwandlungsschicht und der Anode angeordnet ist,
wobei die Lochtransportschicht ein organisches Halbleiterelement (2) enthält,
wobei das organische Halbleiterelement (2) eine Struktur aufweist, die ein Halogenatom und eine an ein Heteroatom gebundene elektronenziehende Gruppe enthält,
wobei die photoelektrische Umwandlungsschicht eine organisch-anorganische Perowskitverbindung der Formel R-M-X₃ enthält, wobei R ein organisches Molekül ist, M ein Metallatom ist und X ein Halogenatom oder ein Chalkogenatom ist, und
wobei das organische Halbleiterelement (2) eine Struktur der Formel (X) aufweist, die ein Halogenatom und elektronenziehende Gruppen enthält, die jeweils an ein Heteroatom gebunden sind: 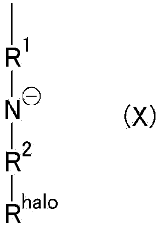 wobei R¹ und R² gleich oder verschieden voneinander sein können und jeweils für eine elektronenziehende Gruppe stehen, und R^{halo} für eine ein Halogenatom enthaltende Gruppe steht.

8. Solarzelle nach Anspruch 7,
wobei die elektronenziehenden Gruppen, für die R¹ und R² in der Formel (X) stehen, jeweils eine Sulfonylgruppe, eine Sulfidgruppe, eine Sulfinylgruppe, eine Thioestergruppe, eine Thioketongruppe, eine Estergruppe, eine Ethergruppe, eine Carbonylgruppe, eine Amidgruppe oder eine Urethangruppe sind.

9. Solarzelle nach Anspruch 8,
wobei die elektronenziehenden Gruppen, für die R¹ und R² in der Formel (X) stehen, jeweils eine Sulfonylgruppe sind.

10. Solarzelle nach Anspruch 7, 8 oder 9,
wobei die ein Halogenatom enthaltende Gruppe, für die R^{halo} in der Formel (X) steht, ein Halogenatom oder eine Alkyl- oder Arylgruppe ist, in der Wasserstoffatome teilweise oder vollständig durch Fluoratome substituiert sind.

11. Solarzelle nach Anspruch 7, 8, 9 oder 10,
wobei das das organische Halbleiterelement (2) Polytriarylamin mit einer Struktureinheit der Formel (2) oder Phthalocyanin der Formel (3) ist: 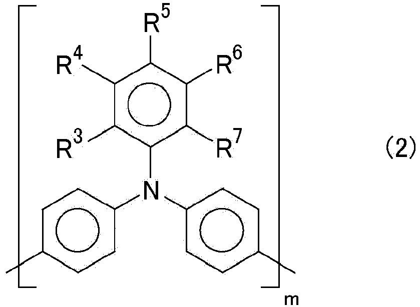 wobei wenigstens eines von R³ bis R⁷ für einen Substituenten mit einer Struktur der Formel (X) steht, die ein Halogenatom und elektronenziehende Gruppen enthält, die jeweils an ein Heteroatom gebunden sind, und m eine ganze Zahl von 2 oder größer ist, 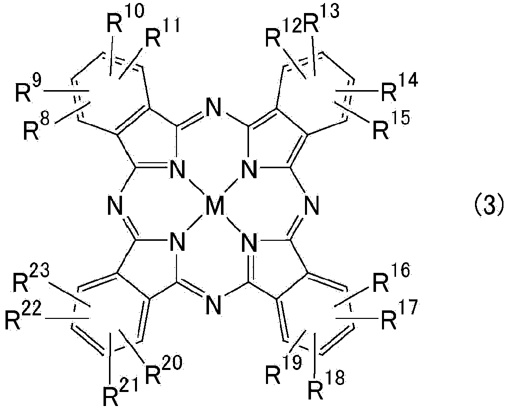 wobei wenigstens eines von R⁸ bis R²³ für einen Substituenten mit der Struktur der Formel (X) steht, die ein Halogenatom und elektronenziehende Gruppen enthält, die jeweils an ein Heteroatom gebunden sind, und M ein Metallelement ist.

## Revendications

1. Cellule solaire comprenant au moins :
une couche de conversion photoélectrique ;
une couche de transport de trous ; et
une anode,
la couche de transport de trous étant disposée entre la couche de conversion photoélectrique et l'anode,
la couche de transport de trous contenant un polymère contenant un atome d'halogène et un constituant de semiconducteur organique (1),
le polymère contenant un atome d'halogène ayant une structure qui contient un atome d'halogène et un groupe attracteur d'électrons lié à un hétéroatome,
dans laquelle la couche de conversion photoélectrique contient un composé de pérovskite organique-inorganique de la formule : R-M-X₃ où R est une molécule organique, M est un atome de métal, et X est un atome d'halogène ou un atome de chalcogène, et
dans laquelle le polymère présente une structure de la formule (X) contenant un atome d'halogène et des groupes attracteurs d'électrons liés chacun à un hétéroatome : 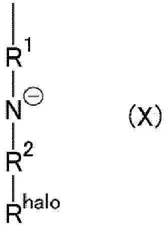 où R¹ et R² peuvent être identiques ou différents l'un de l'autre et représentent chacun un groupe attracteur d'électrons et R^{halo} représente un groupe contenant un atome d'halogène.

2. Cellule solaire selon la revendication 1,
dans laquelle les groupes attracteurs d'électrons représentés par R¹ et R² dans la formule (X) sont chacun un groupe sulfonyle, un groupe sulfure, un groupe sulfinyle, un groupe thioester, un groupe thiocétone, un groupe ester, un groupe éther, un groupe carbonyle, un groupe amide, ou un groupe uréthane.

3. Cellule solaire selon la revendication 2,
dans laquelle les groupes attracteurs d'électrons représentés par R¹ et R² dans la formule (X) sont chacun un groupe sulfonyle.

4. Cellule solaire selon la revendication 1, 2, ou 3,
dans laquelle le groupe contenant un atome d'halogène représenté par R^{halo} dans la formule (X) est un atome d'halogène ou un groupe alkyle ou aryle dans lequel des atomes d'hydrogène sont partiellement ou entièrement substitués par des atomes de fluor.

5. Cellule solaire selon la revendication 1, 2, 3, ou 4,
dans laquelle le polymère contenant un atome d'halogène est un polymère ayant une unité structurelle de la formule (1) : 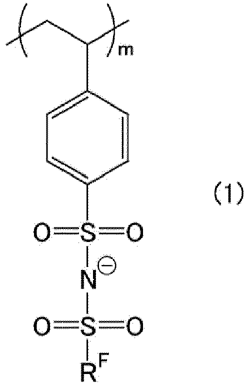 où R^{F} est un atome d'halogène ou un groupe alkyle ou aryle dans lequel les atomes d'hydrogène sont partiellement ou entièrement substitués par des atomes de fluor, et m est un nombre entier de 2 ou supérieur.

6. Cellule solaire selon la revendication 1, 2, 3, 4, ou 5,
dans laquelle la couche de transport de trous présente une concentration métallique de 1 000 ppm ou inférieure.

7. Cellule solaire comprenant au moins :
une couche de conversion photoélectrique ;
une couche de transport de trous ; et
une anode,
la couche de transport de trous étant disposée entre la couche de conversion photoélectrique et l'anode,
la couche de transport de trous contenant un constituant de semiconducteur organique (2),
le constituant de semiconducteur organique (2) étant une structure qui contient un atome d'halogène et un groupe attracteur d'électrons lié à un hétéroatome,
dans laquelle la couche de conversion photoélectrique contient un composé de pérovskite organique-inorganique de la formule : R-M-X₃ où R est une molécule organique, M est un atome de métal, et X est un atome d'halogène ou un atome de chalcogène, et
dans laquelle le constituant de semiconducteur organique (2) présente une structure de la formule (X) contenant un atome d'halogène et des groupes attracteurs d'électrons liés chacun à un hétéroatome : 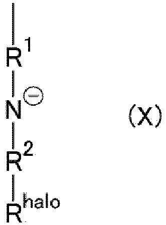 où R¹ et R² peuvent être identiques ou différents l'un de l'autre et représentent chacun un groupe attracteur d'électrons, et R^{halo} représente un groupe contenant un atome d'halogène.

8. Cellule solaire selon la revendication 7,
dans laquelle les groupes attracteurs d'électrons représentés par R¹ et R² dans la formule (X) sont chacun un groupe sulfonyle, un groupe sulfure, un groupe sulfinyle, un groupe thioester, un groupe thiocétone, un groupe ester, un groupe éther, un groupe carbonyle, un groupe amide, ou un groupe uréthane.

9. Cellule solaire selon la revendication 8,
dans laquelle les groupes attracteurs d'électrons représentés par R¹ et R² dans la formule (X) sont chacun un groupe sulfonyle.

10. Cellule solaire selon la revendication 7, 8, ou 9,
dans laquelle le groupe contenant un atome d'halogène représenté par R^{halo} dans la formule (X) est un atome d'halogène ou un groupe alkyle ou aryle dans lequel des atomes d'hydrogène sont partiellement ou entièrement substitués par des atomes de fluor.

11. Cellule solaire selon la revendication 7, 8, 9, ou 10,
dans laquelle le constituant de semiconducteur organique (2) est une polytriarylamine ayant une unité structurelle de la formule (2) ou une phtalocyanine de la formule (3) : 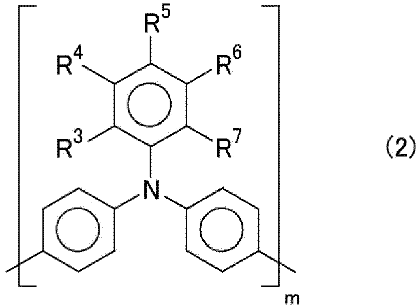 où au moins un de R³ à R⁷ représente un substituant ayant une structure de la formule (X) contenant un atome d'halogène et des groupes attracteurs d'électrons liés chacun à un hétéroatome, et m est un nombre entier de 2 ou supérieur ; 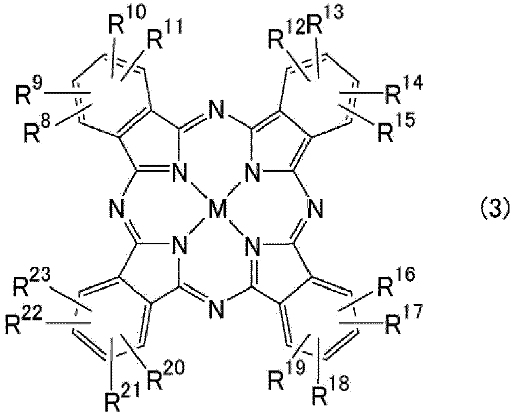 où au moins un de R⁸ à R²³ représente un substituant ayant une structure de la formule (X) contenant un atome d'halogène et des groupes attracteurs d'électrons liés chacun à un hétéroatome, et M est un élément métallique.
